# FASCICULE DE BREVET EUROPEEN

(11) **EP 3 278 128 B1**
(45) Date de publication et mention de la délivrance du brevet: **04.05.2022**
(21) Numéro de dépôt: 16717268.3
(22) Date de dépôt: 30.03.2016
(51) Int. Cl.: G01R 15/18, G01R 15/20, G01R 33/00, G01R 33/022, G01R 33/025, G01R 33/06

(54) **CAPTEUR DE COURANT ET DE TENSION DC ISOLE A FAIBLE DIAPHONIE**
ISOLIERTER GLEICHSTROM- UND SPANNUNGSSENSOR MIT GERINGEM ÜBERSPRECHEN
ISOLATED DC CURRENT AND VOLTAGE SENSOR WITH LOW CROSSTALK

(30) Priorité: 30.03.2015 FR 1552694
(43) Date de publication de la demande: 07.02.2018
(73) Titulaire: Neelogy, 37550 Saint-Avertin (FR)
(72) Inventeur: CIMA, Lionel, Fabien, 37540 Saint-Cyr-sur-Loire (FR)
(74) Mandataire: Gevers & Orès
(86) Numéro de dépôt international: PCT/EP2016/056949
(87) Numéro de publication internationale: WO 2016/156422

(56) Documents cités:
- FR-A1- 2 971 852
- US-A- 5 717 326
- US-A1- 2009 021 249
- VOURC'H ERIC ET AL: "Novel Magnetic Field and Current Sensors Based on Superparamagnetic Transducers", SENSOR LETTERS, AMERICAN SCIENTIFIC PUBLISHERS, US, vol. 7, no. 3, 1 juin 2009 (2009-06-01), pages 293-298, XP009134380, ISSN: 1546-198X, DOI: 10.1166/SL.2009.1063

## Description

La présente invention se rapporte à un dispositif de mesure de champ magnétique et plus particulièrement pour la mesure de courant continu d'un conducteur primaire. Le domaine de l'invention est celui de la mesure des champs magnétiques (magnétomètres) ou de la mesure de courants électriques par l'intermédiaire de leurs champs magnétiques (transducteur de courant sans contact).

Dans le domaine des capteurs de courant DC on connaît les « shunt » qui présentent une grande immunité aux courants perturbateurs et permettent de mesurer des courants précisément, mais ils ne sont pas isolés naturellement. L'utilisation d'un shunt requiert une électronique d'isolation qui en général est coûteuse et volumineuse, peu robuste en environnement contraint (notamment à haute température). Pour des applications de forte tension (>50V), il existe des solutions à isolation optique. En général le matériau utilisé pour la mesure est un matériau dont la résistivité est à constante de dérive thermique sensiblement nulle (constantan par exemple). Parfois on utilise directement du cuivre, il faut alors prévoir une compensation des dérives thermiques, ce qui complique la mesure et la rend en général moins précise. Parmi les défauts du shunt, on peut noter la dissipation de puissance par effet Joule. Pour un capteur de 1000A on a typiquement 10µOhm de résistance et ainsi 10W de dissipation thermique. L'une des conséquences est la grande difficulté d'utilisation d'un shunt dans un système compact du fait de son auto-échauffement.

En général un shunt est également assez volumineux pour permettre justement la dissipation de température sans dépasser la température maximale de celui-ci.

Les capteurs à effet Hall en boucle ouverte sont peu précis et très sensibles aux courants perturbateurs. Pour améliorer leur immunité, on utilise souvent des blindages magnétiques qui introduisent des défauts supplémentaires : ils sont sujets à de fortes rémanences magnétiques qui dérivent dans le temps et en température.

Les capteurs à effet Hall à flux nul sont très précis et reposent sur l'utilisation d'un noyau magnétique qui fait office de blindage magnétique et de canaliseur de champ. Ils sont cependant également sujets à une dérive de la rémanence magnétique dans le temps et en température. Ils sont également gros et encombrant du fait de la présence du noyau en matériau magnétique nécessaire à la canalisation du flux magnétique et au blindage.

La technologie Flux Gate est très sensible et précise mais présente une extrême sensibilité à la diaphonie et aux environnements perturbés du fait de la haute perméabilité de son matériau magnétique. La technologie nécessite alors des solutions de blindage lourdes et volumineuses pour éviter la saturation locale du noyau transducteur sous l'effet d'un champ magnétique.

Les technologies GMR (Giant MagnetoResistance) et/ou AMR (Anisotropic MagnetoResistance) sont relativement sensibles et précises lorsqu'elles utilisent le principe de flux nul. Elles s'intègrent facilement dans un circuit intégré, sauf le bobinage de compensation qui pose problème pour les forts champs. Du coup, elles sont relativement sensibles aux phénomènes de diaphonie et elles présentent aussi une dérive de leur offset magnétique de part la nature ferromagnétique de leur transducteur.

Les capteurs de courant à fibre optique (FOCS en anglais) reposent sur l'effet Faraday. Ils sont très performants pour la mesure de très forts courants (jusque 600kA). Ils présentent une excellente immunité à la diaphonie, et d'excellentes performances lors d'un fonctionnement à flux nul. Celui-ci introduit une forte consommation de puissance pour les forts courants. Cependant, les FOCS ne sont pas applicables a priori pour les besoins d'intégration car ils sont relativement volumineux et nécessitent d'entourer le conducteur primaire.

Les capteurs de courant de type transformateur (Rogowski à air ou transformateur de courant CT à noyau magnétique) sont relativement peu sensibles à la diaphonie, mais ils ne permettent pas de mesurer les composantes DC.

Par ailleurs, pour la plupart des technologies utilisées, les variations brusques de la tension primaire (dV/dt) provoquent des injections de courants parasites qui peuvent être rédhibitoire au niveau de l'électronique du capteur (au mieux saturation des étages de mesure, au pire destruction). C'est particulièrement sensible dans le cas du shunt. Certaines technologies comme le transformateur (CT, Rogowski ou Hall ou Flux Gate) permettent l'utilisation d'un écran électrostatique car la mesure de champ magnétique est réalisée dans un tore à l'extérieur du conducteur primaire.

L'Effet Néel^{®} est très précis. On appelle Effet Néel^{®} la technologie décrite dans le brevet n° FR 2,891,917 et reposant sur l'utilisation d'un bobinage et d'un composite magnétique sans rémanence B(H) dont la dérivée troisième à l'origine présente un extremum (par exemple un composite superparamagnétique). La technologie Effet Néel^{®} est peu sensible aux champs extérieurs du fait de la faible perméabilité de leur matériau magnétique. Ils existent sous une forme « universelle » flexible de type Rogowski pour mesurer les courants continus (brevet FR 2,931,945). Cette topologie présente une forte immunité à la diaphonie en s'appuyant sur le théorème d'Ampère et en faisant une mesure de circulation du champ magnétique sur un contour extérieur sensiblement fermé. Cette topologie présente les mêmes avantages et inconvénients que les autres technologies du point de vue de l'intégration : ils sont gros car ils doivent entourer le conducteur primaire et ils présentent une forte consommation électrique pour fonctionner à flux nul.

Il a été décrit également des topologies compactes de capteurs à Effet Néel^{®} reposant sur une mesure directement sur un busbar voire même à l'intérieur d'un busbar, ceci afin de permettre une réduction importante de la consommation malgré un fonctionnement à flux nul (demandes de brevet français n° 1158584 et n° 1162100). Il est cependant difficile avec ces topologies de pouvoir assurer une bonne tenue en tension, de rajouter en plus un écran électrostatique et de présenter une forte immunité à la diaphonie.

On connaît le document VOURC'H ERIC ET AL : »Novel Magnetic Field and Current Sensors Based on Superparamagnetic Transducers », Sensor Letters, American scientific publishers, us, vol. 7, no 3, 1 juin 2009, un dispositif de mesure magnétique comprenant un capteur de champ magnétique. Le document FR 2 971 852 A1 décrit un unique élément sensible en boucle permettant la réalisation de mesures différentielles par une forme particulière de cette boucle. Le document US 2009/021249 A1 décrit une solution sans noyau avec une paire différentielle.

Le document US 5 717 326 A décrit une solution sans noyau avec deux paires différentielles. La présente invention à pour objet :
Un nouveau capteur très compact, pour ce faire le volume et la masse du capteur doivent être réduits au maximum. Le problème des capteurs magnétiques est qu'ils sont sensibles aux champs de diaphonies générés par des conducteurs extérieurs. Pour s'en affranchir on utilise soit le théorème d'Ampère qui consiste à entourer complètement le conducteur primaire, soit un blindage qui permet de réduire les champs extérieurs au niveau des éléments sensibles. Si on ne veut pas utiliser le théorème d'Ampère pour être compact, et que l'on souhaite éliminer le blindage, alors on constate que l'on doit améliorer l'immunité intrinsèque de l'élément sensible aux champs externes. Cela élimine les structures classiques de type effet Hall, fluxGate, Effet Néel^{®} flexible et GMR/AMR.

Un nouveau capteur apte à assurer une précision de mesure malgré un environnement contraint et notamment, pour des besoins d'intégration, en présence de fortes contraintes thermiques (large gamme de température ambiante et faible résistivité thermique). Pour les capteurs magnétiques, il faut obligatoirement utiliser un système de compensation de flux nul afin de s'affranchir des dérives thermiques du matériau transducteur. Pour une question de dissipation thermique, et afin de ne pas trop échauffer l'environnement, il faut réduire la consommation (au niveau du conducteur primaire et des éléments de transduction). Cela élimine les structures classiques de type effet Hall, FluxGate, Magneto-Optique.

Un nouveau capteur apte à résister aux contraintes de tensions primaires, statiques et dynamiques. Il doit assurer une isolation en tension, typiquement pour tenir jusque 20kV pour les applications basses tensions BT, pour cela il faut assurer une distance suffisante entre l'élément sensible et le conducteur primaire. Pour réduire les courants parasites injectés dans l'électronique par les variations de tensions dV/dt primaires, il faut utiliser un écran électrostatique.

Un nouveau capteur apte à permettre éventuellement une mesure DC et AC à fréquence élevée et avec de forts variations de courants dI/dt. Les conducteurs subissent l'effet de peau en haute fréquence qui déforme les lignes de courant et rend délicate la mesure AC sauf à utiliser un transformateur de courant CT classique. Le nouveau capteur a pour but de prendre en considération cet effet de peau. Les forts di/dt imposeront la prise en compte des effets dynamiques.

Un nouveau capteur apte à permettre une mesure en rétrofit sur busbar. Une solution serait de « coller » un capteur sur un busbar pour dériver une fraction maîtrisée de courant. Il faudrait alors prendre en considération le niveau de champ intense généré par le busbar lui-même.

On atteint au moins l'un des objectifs avec un dispositif de mesure magnétique comprenant un capteur de champ magnétique continu (DC) constitué de au moins quatre éléments discrets longilignes (longueur grande par rapport au diamètre ou petit côté de la section, par exemple un rapport supérieur à 2, 3, 5 ou 10), chaque élément étant constitué d'au moins un bobinage et d'un matériau magnétique sans rémanence, ces éléments discrets étant sensiblement identiques. Selon l'invention, le capteur de champ magnétique comprend :
- un premier élément discret orienté suivant une direction donnée, un second élément lui est associé pour constituer une première paire différentielle orientée suivant une direction sensiblement identique mais dans un sens opposé, et
- deux autres éléments constituant une seconde paire différentielle sensiblement identique à la première mais orientée à nouveau suivant une direction sensiblement identique à la direction de la première paire mais dans des sens respectivement opposés.

Avec la présente invention, on réalise un capteur de champ magnétique comprenant deux paires d'éléments transducteurs disposées suivant les lignes de champs magnétiques pour réaliser la mesure et de façon à s'immuniser au maximum contre toute perturbation due à des conducteurs extérieurs. En pratique et de façon avantageuse, le dispositif selon l'invention peut être utilisé comme transducteur connecté à, et piloté par une unité de traitement. Différents types de connexions et différents types de modes de mesure peuvent être envisagés. De façon non limitative, le dispositif selon l'invention peut être utilisé comme transducteur pour l'application telle que décrite dans la demande de brevet français n° 1453276.

Selon une caractéristique avantageuse de l'invention pour la mesure de courant continu ou de tension continue, le dispositif selon l'invention comprend en outre un composant de conversion apte à convertir un mesurande, c'est-à-dire une grandeur à mesurer, en un champ magnétique dont la projection le long d'un chemin constitué par les quatre éléments discrets est non nulle. Pour la mesure de courant notamment, le composant de conversion peut être constitué d'un conducteur composé d'au moins un élément de deux barres formant un U. Ce conducteur est placé en série dans le circuit électrique dans lequel on souhaite mesurer un courant.

Pour la mesure de tension sur un conducteur primaire, le composant de conversion peut être constitué d'au moins un bobinage multispire connecté au conducteur primaire en parallèle via une résistance de forte impédance, typiquement supérieure à 100kOhms.

En complément notamment de ce qui précède, les éléments discrets peuvent être des transducteurs à Effet Néel^{®} constitués chacun de au moins un bobinage et un noyau superparamagnétique.

Selon l'invention, afin d'homogénéiser le champ magnétique dans les éléments de mesure, le composant de conversion de courant vers un champ magnétique peut être constitué de au moins deux éléments conducteurs placés au dessus et au dessous de la cellule de mesure.

Le composant de conversion de courant vers un champ magnétique décrit ci-dessus peut être constitué par deux barres supplémentaires sensiblement identiques générant un champ sensiblement nul au niveau des éléments discrets de mesure. L'intérêt de ces deux barres est de dériver une forte proportion du courant primaire (>30%, >50%, >75%, >90%) sans que celui-ci ne génère de champ magnétique dans les éléments discrets de mesure. Ainsi, cela permet d'augmenter la gamme de mesure en courant avec le même dimensionnement des éléments discrets de mesure de champ.

Avantageusement, le composant de conversion de courant vers un champ magnétique peut être constitué de plusieurs couches de conducteurs isolées entre elles. Cela permet de s'affranchir de l'effet de peau en haute fréquence.

Le composant de conversion de courant vers un champ magnétique peut être également placé en dérivation sur le conducteur primaire (par exemple directement sur un busbar). Dans cette configuration, on choisira préférentiellement une orientation des éléments discrets de mesure de telle sorte que le conducteur primaire principal génère une composante de champ magnétique perpendiculaire aux éléments discrets de mesure. On précise ici primaire principal car, le courant étant pris en dérivation, le capteur fait lui-même partie du conducteur primaire, le conducteur primaire principal étant celui qui ne contribue pas directement au champ magnétique à mesurer.

Dans cette configuration en dérivation, on veillera de préférence à ce que le composant de conversion de courant vers un champ magnétique et le conducteur primaire principal soient constitués de matériaux conducteurs sensiblement identiques.

Selon un autre aspect de l'invention, il est prévu un procédé de mesure de courant fort consistant à placer un dispositif de mesure tel que décrit ci-dessus en dérivation d'un conducteur primaire afin de capter une fraction de courant primaire.

Par ailleurs, les éléments discrets peuvent être sensiblement placés dans un seul et même plan. Cela permet de faciliter l'utilisation d'un écran électrostatique qui entoure l'ensemble de la cellule de mesure.

A titre d'exemple non limitatif, la taille d'un élément discret (la bobine avec son noyau) peut être de l'ordre de 10mm de long et de 3mm de diamètre. De façon générale, la longueur peut être > 1mm ou > 3mm ou >10mm ( un équilibre doit être trouvé entre la compacité et la longueur, plus c'est long meilleure est la performance). Le diamètre peut être > 500µm ou >1mm ou >2mm (un équilibre doit être trouvé entre la compacité et le diamètre, plus le diamètre est grand meilleure est la performance). Il n'y a pas de limite haute car il existe des applications où la performance prévaut sur la compacité. Par ailleurs, les éléments discrets sont très proches les uns des autres, voire en contact. Plus ils sont éloignés, moins bonne est la performance.

D'autres avantages et caractéristiques de l'invention apparaîtront à l'examen de la description détaillée d'un mode de mise en œuvre nullement limitatif, et des dessins annexés, sur lesquels :
La figure 1 illustre plusieurs exemples de topologies doublement différentielles selon l'invention,
La figure 2 illustre plusieurs exemples de formes de conducteurs primaires pour générer le champ à mesurer,
La figure 3 illustre plusieurs exemples de mesure dans deux plans avec à droite une structure à plusieurs étages pour uniformiser le champ primaire,
La figure 4 illustre un exemple de mesure à plusieurs étages pour uniformiser le champ primaire avec une mesure dans un seul plan,
La figure 5 illustre un exemple de transducteur avec un composant de conversion IpHp constitué de deux parties situées au dessus et en dessous de la cellule de mesure et de deux busbars,
La figure 6 illustre un exemple de transducteur pour la mesure de courant, et
La figure 7 illustre un exemple de transducteur de courant bobiné pour la mesure de petits courants et/ou de tensions, à gauche, le convertisseur IpHp avec les 4 bobinages agencés par exemple sur un support PCB ainsi que la direction des champs primaires ; à droite l'orientation des 4 éléments discrets de mesure vue de côté.

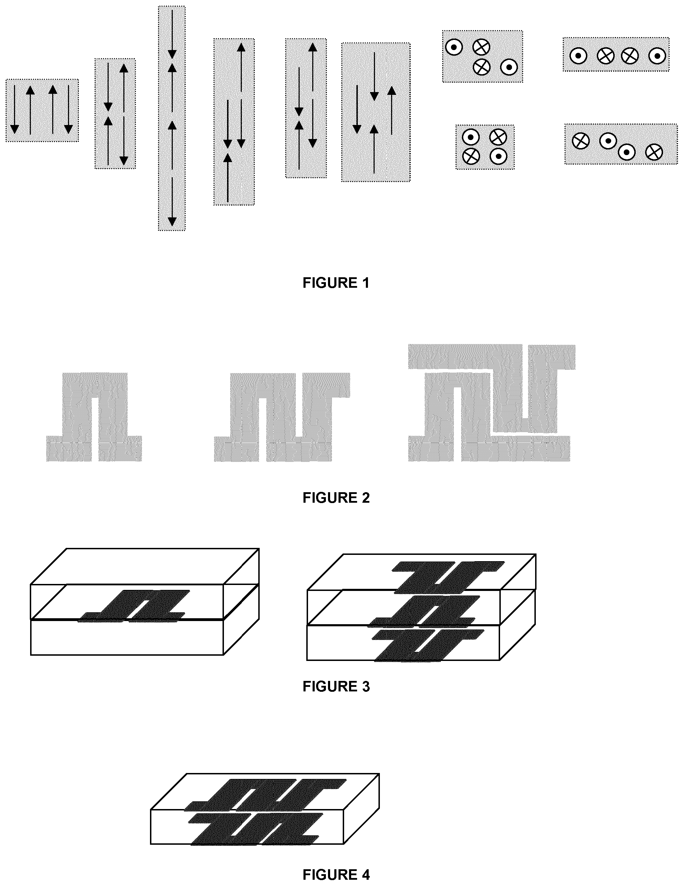

Sur la figure 1 on voit plusieurs exemples de topologies doublement différentielles pour la réalisation d'un capteur de champ magnétique. On obtient un capteur compact en utilisant une cellule de mesure basée sur l'utilisation d'éléments « discrets » longilignes permettant la mesure locale d'un champ magnétique orienté mais en cherchant à optimiser l'immunité à la diaphonie due aux conducteurs extérieurs. Pour cela on utilise au moins quatre éléments discrets longilignes, sensiblement identiques et répartis dans l'espace suivant une topologie doublement différentielle comme on le voit sur la figure 1. Partant d'un premier élément discret orienté suivant une direction donnée, le second élément qui lui est associé pour constituer une première paire différentielle orienté suivant une direction sensiblement identique mais dans un sens opposé. Ainsi cette première paire sera-t-elle insensible aux champs externes uniformes quelle que soit leurs directions. Il est à noté que cette paire différentielle ne sera sensible qu'aux gradients des champs externes suivant une direction privilégiée. La seconde paire différentielle sera sensiblement identique à la première mais orientée à nouveau suivant une direction sensiblement identique à la première paire mais dans un sens opposé. Ainsi cette cellule de mesure sera-t-elle insensible aux champs uniformes mais également aux gradients uniformes d'un champ externe. Il restera une sensibilité au gradient du gradient de champ et en ce sens il est préférable de chercher à rapprocher au maximum les éléments les uns des autres pour diminuer cette sensibilité résiduelle.

Afin de permettre la mesure d'une grandeur autre qu'un champ magnétique, on associe cette cellule de mesure avec un composant permettant la conversion du mesurande en un champ magnétique, appelé champ magnétique primaire Hp, dont la projection le long du chemin constitué par les 4 éléments discrets est non nulle. De façon préférentielle pour améliorer la linéarité, le champ primaire sera sensiblement uniforme au niveau de chacun des quatre éléments discrets.

Pour un capteur de courant, il s'agit par exemple d'un conducteur électrique parcouru par un courant image du courant primaire, composant dénommé IpHp. De façon préférentielle ce conducteur IpHp est constitué d'éléments de barre formant au moins un U tel que représenté par exemple sur la figure 2.

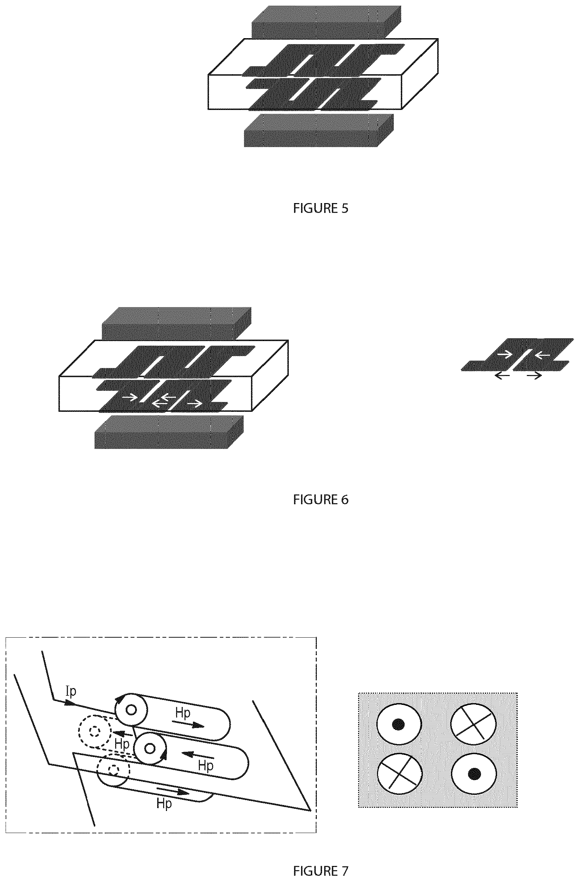

Pour un capteur de tension ou pour un capteur de faible intensité de courant, il s'agit par exemple d'un conducteur parcouru par un courant image de la tension primaire et le composant sera dénommé UpHp. De façon préférentielle ce conducteur UpHp est un bobinage multispire connecté soit en parallèle d'une tension primaire via une résistance de très forte impédance, soit directement en série avec un courant de faible intensité. Un exemple de réalisation est représenté sur la figure 7.

On peut imaginer que les éléments sensibles soient des transducteurs à effet Hall, ou bien de type Flux Gate, ou bien AMR/GMR, ou bien à Effet Néel^{®}. Le défaut des transducteurs FluxGate ou bien AMR/GMR est qu'ils sont très sensibles aux champs externes perpendiculaires à la direction de mesure. Ainsi le bénéfice de la forme doublement différentiel sera-t-il perdu par des effets non linéaires introduits par les champs externes.

De façon préférentielle, les éléments discrets seront des transducteurs à Effet Néel^{®} constitués chacun de au moins un bobinage et d'un noyau superparamagnétique.

Le dispositif selon l'invention permet d'assurer une précision de mesure malgré un environnement contraint et notamment en présence d'une faible résistivité thermique. Il est important de fonctionner à flux nul avec un système de type rétroaction de champ, afin d'éliminer les effets des dérives des matériaux transducteurs (Hall ou Effet Néel^{®}). Il faut donc utiliser un bobinage de compensation de champ et en ce sens il est utilisé de façon préférentielle un élément discret de type bobinage à Effet Néel.

Afin d'améliorer les performances du capteur en terme de linéarité, on utilise dans le cas des capteurs de courant une solution permettant d'uniformiser au maximum le champ primaire et de l'orienter au maximum dans la direction des bobinages de mesure. On utilisera alors préférentiellement un composant de conversion IpHp constitué de au moins deux éléments conducteurs placés au dessus et au dessous de la cellule de mesure comme on le voit sur les figures 3 et 4.

Afin de réduire la dissipation thermique dans le capteur, le composant de conversion du courant primaire en champ primaire pourra être connecté en dérivation du conducteur primaire. Ainsi, une fraction de courant seulement sera dérivée permettant ainsi de réduire la puissance nécessaire à la contre réaction pour fonctionner à flux nul. De façon préférentielle cette dérivation sera placée entre deux busbars sensiblement identiques de telle sorte que le champ magnétique généré au niveau des cellules de mesure par le courant qui n'est pas dérivé dans le composant de conversion IpHp soit minimal, voire nul. Un exemple de réalisation est décrit sur la figure 5. Pour une question de coût, on pourra alors utiliser un busbar avec de simples rainurages pour constituer le composant de conversion IpHp.

Afin d'assurer que le ratio entre le courant dérivé et le courant primaire total soit bien indépendant de la température, on choisira de façon préférentielle un matériau conducteur identique pour toutes les parties du composant de conversion IpHp. C'est une des raisons pour lesquelles on ne peut pas réaliser utilement cette mesure par dérivation avec la technologie shunt.

Le dispositif selon l'invention permet de résister aux contraintes de tensions primaires. De façon préférentielle, on utilise une cellule de mesure suivant une topologie permettant de placer les éléments discrets dans un seul et même volume compact. Ainsi, il sera possible dans un espace restreint d'assurer une distance d'isolement (distance minimale entre les éléments de conversion et le ou les conducteurs primaires) la plus grande possible. De même, il sera plus aisé de placer les éléments de mesure dans une cage de Faraday reliée à un potentiel fixe. Ainsi de façon préférentielle, la cellule de mesure sera entourée d'un écran électrostatique conducteur. Il est possible de réaliser l'ensemble des éléments discret en utilisant une technologie de type PCB (Printed Circuit Board), qui présente l'avantage de permettre une grande maîtrise de la symétrie des quatre éléments de bobinages. Le circuit magnétique peut être logé dans le PCB suivant une technique connue de composant enfoui, ou bien directement en chargeant le composite isolant (par exemple de l'epoxy) avec des particules magnétiques (par exemple des nanoparticules superparamagnétiques). De même, l'écran électrostatique peut être constitué de plans de cuivre de part et d'autre du PCB, refermés aux extrémités par des métallisations spécifiques.

Le dispositif selon l'invention permet une mesure DC et AC à fréquence élevée et malgré de forts variations de courant dI/dt. Afin de permettre une mesure DC et AC à fréquence élevée, le composant de conversion IpHp doit être peu sensible à la fréquence. Pour cela, on prend soin d'utiliser une épaisseur pour les composants de conversion IpHp qui soit sensiblement inférieure à l'épaisseur de peau calculée à la fréquence d'utilisation maximale. Si pour des raisons thermiques par exemple et/ou d'encombrement il n'est pas possible de respecter cette contrainte, alors les composants de conversion IpHp seront de façon préférentielle constituée de plusieurs couches de conducteurs isolées entre elles. Il sera alors possible de mesurer aussi bien les composantes DC et AC au niveau de la cellule de mesure.

Le dispositif selon l'invention permet une mesure en dérivation sur busbar. Afin de mesurer en rétrofit le courant circulant dans un conducteur de type busbar, on peut utiliser le capteur décrit ci-dessus et simplement le « fixer » sur ledit busbar afin d'en dériver une fraction du courant primaire. Le champ magnétique au niveau des éléments discrets de mesure sera alors composé du champ primaire à mesurer décalé du champ provenant du busbar. Afin de limiter au maximum les non linéarités que pourrait introduire le busbar, on choisira de façon préférentielle d'orienter les éléments discrets dans une direction sensiblement perpendiculaire à celle du champ primaire généré par le busbar en l'absence de dérivation. Ainsi, seul le courant de dérivation générera un champ dans l'axe d'orientation des éléments discrets.

La figure 6 illustre un exemple de transducteur pour la mesure de courant. Sur la figure de gauche, on distingue un dispositif qui peut être identique à celui de la figure 5, la figure de droite illustrant plus spécifiquement un busbar en forme de U.

Bien sûr, l'invention n'est pas limitée aux exemples qui viennent d'être décrits et de nombreux aménagements peuvent être apportés à ces exemples sans sortir du cadre de l'invention qui est définie par les revendications annexées.

## Revendications

1. Dispositif de mesure magnétique comprenant un capteur de champ magnétique DC constitué de au moins quatre éléments discrets longilignes de mesure de champ magnétique, chaque élément étant constitué d'au moins un bobinage et d'un matériau magnétique sans rémanence, ces éléments discrets étant sensiblement identiques ; **caractérisé en ce que** lesdits quatre éléments discrets longilignes comprennent :
- un premier élément discret orienté suivant une direction donnée, un second élément lui est associé pour constituer une première paire différentielle orientée suivant une direction sensiblement identique mais dans un sens opposé, et
- deux autres éléments constituant une seconde paire différentielle sensiblement identique à la première mais orientée à nouveau suivant une direction sensiblement identique à la direction de la première paire mais dans des sens respectivement opposés.

2. Dispositif selon la revendication 1 pour la mesure de courant continu ou de tension continue, **caractérisé en ce qu'**il comprend en outre un composant de conversion apte à convertir un mesurande en un champ magnétique dont la projection le long d'un chemin constitué par les quatre éléments discrets est non nulle.

3. Dispositif selon la revendication 2 pour la mesure de courant sur un conducteur primaire, **caractérisé en ce que** le composant de conversion est constitué d'un conducteur composé d'au moins un élément de deux barres formant un U.

4. Dispositif selon la revendication 2 pour la mesure de tension sur un conducteur primaire, **caractérisé en ce que** le composant de conversion est constitué d'au moins un bobinage multispire connecté au conducteur primaire en parallèle via une résistance de forte impédance.

5. Dispositif selon l'une quelconque des revendications précédentes, **caractérisé en ce que** les éléments discrets sont des transducteurs à Effet Néel constitués chacun de au moins un bobinage et un noyau superparamagnétique.

6. Dispositif selon la revendication 3, **caractérisé en ce que** le composant de conversion de courant vers un champ magnétique est constitué de au moins deux éléments conducteurs placés au dessus et au dessous de la cellule de mesure.

7. Dispositif selon la revendication 3, **caractérisé en ce que** le composant de conversion de courant vers un champ magnétique est constitué par deux barres supplémentaires sensiblement identiques générant un champ sensiblement nul au niveau des éléments discrets de mesure.

8. Dispositif selon la revendication 3, **caractérisé en ce que** le composant de conversion de courant vers un champ magnétique est constitué de plusieurs couches de conducteurs isolées entre elles.

9. Dispositif selon la revendication 3, **caractérisé en ce que** le composant de conversion de courant vers un champ magnétique est placé en dérivation sur le conducteur primaire de telle sorte que ce conducteur primaire génère une composante de champ magnétique perpendiculaire aux éléments discrets de mesure.

10. Dispositif selon la revendication 9, **caractérisé en ce que** le composant de conversion de courant vers un champ magnétique et le conducteur primaire sont constitués de matériaux conducteurs sensiblement identiques.

11. Dispositif selon l'une quelconque des revendications précédentes, **caractérisé en ce que** les éléments discrets sont sensiblement placés dans un seul et même plan.

12. Procédé de mesure de courant fort consistant à placer un dispositif de mesure, selon l'une quelconque des revendications 2 à 11, en dérivation d'un conducteur primaire afin de capter une fraction de courant primaire.

## Patentansprüche

1. Vorrichtung zur Magnetmessung, umfassend einen Gleichstrom-Magnetfeldsensor, der aus mindestens vier langgestreckten diskreten Magnetfeldmesselementen besteht, wobei jedes Element aus mindestens einer Wicklung und einem Magnetmaterial ohne Remanenz besteht, wobei diese diskreten Elemente im Wesentlichen identisch sind; **dadurch gekennzeichnet, dass** die vier langgestreckten diskreten Elemente umfassen:
- ein erstes diskretes Element, das in einer gegebenen Richtung ausgerichtet ist, ein zweites Element ist ihm zugeordnet, um ein erstes Differenzpaar zu bilden, das in einer im Wesentlichen identischen Richtung, aber in einer Gegenrichtung ausgerichtet ist, und
- zwei andere Elemente, die ein zweites Differenzpaar bilden, das im Wesentlichen identisch zum ersten ist, aber wiederum in einer im Wesentlichen identischen Richtung zur Richtung des ersten Paars, aber in jeweiligen Gegenrichtungen ausgerichtet.

2. Vorrichtung nach Anspruch 1 zur Messung von Gleichstrom oder von Gleichspannung, **dadurch gekennzeichnet, dass** sie weiter eine Wandlungskomponente umfasst, die imstande ist, eine Messgröße in ein Magnetfeld umzuwandeln, dessen Projektion entlang eines durch die vier diskreten Elemente gebildeten Pfads ungleich null ist.

3. Vorrichtung nach Anspruch 2 zur Messung von Strom auf einem Primärleiter, **dadurch gekennzeichnet, dass** die Wandlungskomponente aus einem Leiter besteht, der aus mindestens einem Element mit zwei Schienen zusammengesetzt ist, die ein U bilden.

4. Vorrichtung nach Anspruch 2 zur Messung von Spannung auf einem Primärleiter, **dadurch gekennzeichnet, dass** die Wandlungskomponente aus mindestens einer mehrfach gewundenen Wicklung besteht, die über einen Widerstand mit hoher Impedanz parallel zum Primärleiter geschaltet ist.

5. Vorrichtung nach einem der vorstehenden Ansprüche, **dadurch gekennzeichnet, dass** die diskreten Elemente Transduktoren mit Néel-Effekt sind, die jeweils aus mindestens einer Wicklung und einem superparamagnetischen Kern bestehen.

6. Vorrichtung nach Anspruch 3, **dadurch gekennzeichnet, dass** die Komponente zum Wandeln von Strom in ein Magnetfeld aus mindestens zwei leitfähigen Elementen besteht, die oberhalb und unterhalb der Messzelle platziert sind.

7. Vorrichtung nach Anspruch 3, **dadurch gekennzeichnet, dass** die Komponente zum Wandeln von Strom in ein Magnetfeld aus zwei zusätzlichen, im Wesentlichen identischen Schienen besteht, die ein Feld erzeugen, das an den diskreten Messelementen im Wesentlichen null ist.

8. Vorrichtung nach Anspruch 3, **dadurch gekennzeichnet, dass** die Komponente zum Wandeln von Strom in ein Magnetfeld aus mehreren Leiterschichten besteht, die untereinander isoliert sind.

9. Vorrichtung nach Anspruch 3, **dadurch gekennzeichnet, dass** die Komponente zum Wandeln von Strom in ein Magnetfeld derart abzweigend auf dem Primärleiter platziert ist, dass dieser Primärleiter eine Magnetfeldkomponente erzeugt, die senkrecht zu den diskreten Messelementen ist.

10. Vorrichtung nach Anspruch 9, **dadurch gekennzeichnet, dass** die Komponente zum Wandeln von Strom in ein Magnetfeld und der Primärleiter aus im Wesentlichen identischen leitfähigen Materialien bestehen.

11. Vorrichtung nach einem der vorstehenden Ansprüche, **dadurch gekennzeichnet, dass** die diskreten Elemente im Wesentlichen in einer einzigen und selben Ebene platziert sind.

12. Verfahren zum Messen von Starkstrom, bestehend aus Platzieren einer Messvorrichtung nach einem der Ansprüche 2 bis 11 abzweigend von einem Primärleiter, um einen Primärstromanteil zu erfassen.

## Claims

1. Device for magnetic measurement comprising a DC magnetic field sensor constituted by at least four discrete elongate elements, each element being constituted by at least one coil and a magnetic material without remanence, these discrete elements being substantially identical; **characterized in that** said four discrete elongate elements comprise:
- a first discrete element orientated in a given direction, a second element is associated therewith in order to constitute a first differential pair orientated in a substantially identical direction but opposite way, and
- two other elements constituting a second differential pair substantially identical to the first but once more orientated in a substantially identical direction to the direction of the first pair but respectively opposite way.

2. Device according to claim 1 for measuring direct current or direct voltage, **characterized in that** it comprises moreover a conversion component capable of converting a measurand to a magnetic field the projection of which along a path constituted by the four discrete elements is non-zero.

3. Device according to claim 2 for measuring current on a primary conductor, **characterized in that** the conversion component is constituted by a conductor composed of at least one element of two bars forming a U.

4. Device according to claim 2 for measuring voltage on a primary conductor, **characterized in that** the conversion component is constituted by at least one multi-turn coil connected in parallel to the primary conductor via a resistor with a high impedance.

5. Device according to any one of the preceding claims, **characterized in that** the discrete elements are Neel Effect transducers each constituted by at least one coil and a superparamagnetic core.

6. Device according to claim 3, **characterized in that** the component converting the current to a magnetic field is constituted by at least two conductive elements placed above and below the measurement cell.

7. Device according to claim 3, **characterized in that** the component converting the current to a magnetic field is constituted by two substantially identical additional bars generating a substantially zero field at the level of the discrete measurement elements.

8. Device according to claim 3, **characterized in that** the component converting the current to a magnetic field is constituted by several layers of conductors that are isolated from each other.

9. Device according to claim 3, **characterized in that** the component converting the current to a magnetic field is placed in bypass on the primary conductor so that this primary conductor generates a magnetic field component perpendicular to the discrete measurement elements.

10. Device according to claim 9, **characterized in that** the component converting the current to a magnetic field and the primary conductor are constituted by substantially identical conductive materials.

11. Device according to any one of the preceding claims, **characterized in that** the discrete elements are substantially placed in one and the same plane.

12. Method for measuring high current consisting of placing a measurement device, according to any one of claims 2 to 11, in bypass of a primary conductor in order to capture a fraction of primary current.
